Europäisches Patentamt

European Patent Office

Office européen des brevets

(19)

(11) **EP 0 779 988 B1**

(12) **EUROPÄISCHE PATENTSCHRIFT**

(45) Veröffentlichungstag und Bekanntmachung des
Hinweises auf die Patenterteilung:
**20.05.1998   Patentblatt 1998/21**

(21) Anmeldenummer: **95928986.9**

(22) Anmeldetag: **25.08.1995**

(51) Int Cl.⁶: **G01R 15/24**

(86) Internationale Anmeldenummer:
**PCT/DE95/01138**

(87) Internationale Veröffentlichungsnummer:
**WO 96/07922 (14.03.1996 Gazette 1996/12)**

(54) **VERFAHREN UND VORRICHTUNG ZUM MESSEN EINES ELEKTRISCHEN WECHSELSTROMES MIT TEMPERATURKOMPENSATION**

PROCESS AND DEVICE FOR MEASURING AN ALTERNATING ELECTRIC CURRENT WITH TEMPERATURE COMPENSATION

PROCEDE ET DISPOSITIF PERMETTANT DE MESURER UN COURANT ALTERNATIF ELECTRIQUE AVEC COMPENSATION THERMIQUE

(84) Benannte Vertragsstaaten:
**AT BE CH DE FR GB IT LI NL SE**

(30) Priorität: **09.09.1994   DE 4432146**

(43) Veröffentlichungstag der Anmeldung:
**25.06.1997   Patentblatt 1997/26**

(73) Patentinhaber: **SIEMENS
AKTIENGESELLSCHAFT
80333 München (DE)**

(72) Erfinder:
* **BOSSELMANN, Thomas
  D-91054 Erlangen (DE)**
* **MENKE, Peter
  D-91054 Erlangen (DE)**

(56) Entgegenhaltungen:
EP-A- 0 088 419          EP-A- 0 557 090
WO-A-91/01500            US-A- 4 973 899

**Beschreibung**

Die Erfindung betrifft ein Verfahren und eine Vorrichtung zum Messen eines elektrischen Wechselstromes.

Es sind optische Meßverfahren und Meßvorrichtungen zum Messen eines elektrischen Stromes bekannt, bei denen der magnetooptische Faraday-Effekt ausgenutzt wird. Unter dem Faraday-Effekt versteht man die Drehung der Polarisationsebene von linear polarisiertem Licht in Abhängigkeit von einem Magnetfeld. Der Drehwinkel ist dabei proportional zum Wegintegral über dem magnetischen Feld entlang des von dem Licht zurückgelegten Weges mit der Verdet-Konstanten als Proportionalitätskonstanten. Die Verdet-Konstante ist abhängig von dem Material, in dem das Licht verläuft, und von der Wellenlänge des Lichts. Zum Messen eines elektrischen Stromes in einem Stromleiter ist in der Nähe des Stromleiters eine den Faraday-Effekt zeigende Sensoreinrichtung angeordnet, die aus einem optisch transparenten Material und im allgemeinen aus Glas besteht und mit einem oder mehreren, einen Lichtpfad bildenden massiven Körpern oder auch mit einem Lichtwellenleiter gebildet sein kann. Durch die Sensoreinrichtung wird linear polarisiertes Licht geschickt. Das von dem elektrischen Strom erzeugte Magnetfeld bewirkt eine Drehung der Polarisationsebene des Lichtes in der Sensoreinrichtung um einen Drehwinkel, die von einer Auswerteeinheit als Maß für die Stärke des Magnetfeldes und damit für die Stärke des elektrischen Stromes ausgewertet werden kann. Im allgemeinen umgibt die Sensoreinrichtung den Stromleiter, so daß das polarisierte Licht den Stromleiter in einem quasi geschlossenen Weg umläuft. In diesem Fall ist der Betrag des Polarisationsdrehwinkels in guter Näherung direkt proportional zur Amplitude des Meßstromes.

In einer aus WO 91/01501 bekannten Ausführungsform einer optischen Meßvorrichtung zum Messen eines elektrischen Stromes ist die Sensoreinrichtung als Teil einer optischen Monomode-Faser ausgebildet, die den Stromleiter in Form einer Meßwicklung umgibt. Das polarisierte Meßlicht umläuft den Stromleiter daher bei einem Durchlauf N-mal, wenn N die Anzahl der Windungen der Meßwicklung ist. Beim sogenannten Transmissionstyp durchläuft das Meßlicht die Meßwicklung nur einmal. Beim Reflexionstyp ist dagegen das andere Ende der Faser verspiegelt, so daß das Meßlicht nach einem ersten Durchlauf die Meßwicklung ein zweites Mal in umgekehrter Richtung durchläuft. Wegen der Nicht-Reziprokität des Faraday-Effekts ist deshalb der Drehwinkel beim Reflexionstyp bei gleicher Meßwicklung doppelt so groß wie beim Transmissionstyp.

Aus der EP-B-0 088 419 ist eine optische Meßvorrichtung zum Messen eines Stromes bekannt, bei der die Sensoreinrichtung als massiver Glasring um den Stromleiter ausgebildet ist. Licht einer Lichtquelle wird mit einem Polarisator linear polarisiert und dann in die Sensoreinrichtung eingekoppelt. Das linear polarisierte Licht durchläuft die Sensoreinrichtung einmal und wird dann mit einem Wollaston-Prisma als polarisierendem Strahlteiler in zwei linear polarisierte Lichtteilsignale A und B mit senkrecht zueinander gerichteten Polarisationsebenen geteilt. Jedes dieser beiden Lichtsignale A und B wird über eine zugehörige optische Übertragungsfaser zu einem zugehörigen Lichtdetektor übertragen und in ein entsprechendes elektrisches Signal PA und PB umgewandelt. Aus diesen beiden Signalen PA und PB wird in einer Recheneinheit ein intensitätsnormiertes Meßsignal M = (PA-PB)/(PA+PB) gebildet. Dieses Meßsignal M ist unabhängig von Intensitätsschwankungen der Lichtquelle oder Dämpfungen in den optischen Zuleitungen.

Ein Problem bei solchen optischen Meßverfahren und Meßvorrichtungen zur Strommessung stellen Störeinflüsse durch zusätzliche lineare Doppelbrechung in den optischen Materialien der Sensoreinrichtung und der optischen Übertragungsstrecken dar. Solche zusätzliche lineare Doppelbrechung kann durch mechanische Spannungen, die beispielsweise durch Verbiegen oder Vibrationen hervorgerufen werden, oder durch Temperaturänderungen verursacht werden. Diese durch Störgrößen bewirkte, lineare Doppelbrechung führt zu einer unerwünschten Änderung des Arbeitspunktes und der Meßempfindlichkeit.

Zur Kompensation von Temperatureinflüssen sind bereits verschiedene Temperaturkompensationsverfahren bekannt.

In US 4 755 665 wird ein Temperaturkompensationsverfahren für eine magnetooptische Meßvorrichtung zum Messen von Wechselströmen vorgeschlagen. Bei diesem Verfahren werden die analog zu der zuvor beschriebenen, aus EP-B-0 088 419 bekannten Meßvorrichtung gewonnenen elektrischen Signale PA und PB jeweils in einem Filter in ihre Gleichstromanteile PA(DC) bzw. PB(DC) und ihre Wechselstromanteile PA(AC) bzw. PB(AC) zerlegt. Aus dem Wechselstromanteil PA(AC) bzw. PB(AC) und dem Gleichstromanteil PA(DC) bzw. PB(DC) wird für jedes Signal PA und PB zum Ausgleich auch von unterschiedlichen Intensitätsschwankungen in den beiden Übertragungsstrecken für die Lichtsignale A und B der Quotient QA = PA(AC)/PA(DC) bzw. QB = PB(AC)/PB(DC) aus seinem Wechselstromanteil PA(AC) bzw. PB(AC) und seinem Gleichstromanteil PA(DC) bzw. PA(DC) gebildet. Aus jedem dieser beiden Quotienten QA und QB wird ein zeitlicher Mittelwert MW(QA) und MW(QB) gebildet, und aus diesen beiden Mittelwerten MW(QA) und MW(QB) wird schließlich ein Quotient Q = MW(QA)/MW(QB) gebildet. Im Rahmen eines Iterationsverfahrens wird durch Vergleich mit in einer Wertetabelle (Look-up-table) gespeicherten, geeichten Werten ein Korrekturfaktor K für den ermittelten Quotienten Q erhalten. Der um diesen Korrekturfaktor K korrigierte Wert Q*K wird als temperaturkompensierter Meßwert für einen zu messenden elektrischen Wechselstrom herangezogen. Mit diesem Verfahren kann die Temperaturempfindlichkeit auf etwa 1/50 herabgesetzt werden.

Aus EP-A-0 557 090 ist ein weiteres Temperaturkompensationsverfahren für eine optische Meßvorrichtung zum Messen magnetischer Wechselfelder bekannt, die den Faraday-Effekt ausnutzt und daher auch zum Messen elektrischer Wechselströme geeignet ist. Bei diesem bekannten Verfahren wird das linear polarisierte Meßlicht nach Durchlaufen einer Sensoreinrichtung in einem Analysator in zwei unterschiedlich linear polarisierte Lichtteilsignale A und B aufgespalten, und es wird zur Intensitätsnormierung für jedes der beiden zugehörigen elektrischen Signale PA und PB gesondert der Quotient QA = PA(AC)/PA(DC) bzw. QB = PB(AC)/PB(DC) aus seinem zugehörigen Wechselstromanteil PA(AC) bzw. PB(AC) und seinem zugehörigen Gleichstromanteil PA(DC) bzw. PB(DC) gebildet. Aus den beiden Quotienten QA und QB wird nun in einer Recheneinheit ein Meßsignal $M = 1/((\alpha/QA)-(\beta/QB))$ gebildet mit den reellen Konstanten $\alpha$ und $\beta$, die die Beziehung $\alpha+\beta = 1$ erfüllen. Dieses Meßsignal M wird als weitgehend unabhängig von durch Temperaturänderungen verursachten Änderungen der Verdet-Konstanten und der zirkularen Doppelbrechung im Sensoreinrichtung beschrieben. Über eine Kompensation der temperaturinduzierten linearen Doppelbrechung ist nichts ausgesagt. Die Konstanten $\alpha$ und $\beta$ werden experimentell bestimmt.

Der Erfindung liegt nun die Aufgabe zugrunde, ein Verfahren und eine Vorrichtung zum Messen eines elektrischen Wechselstromes mit Hilfe einer den Faraday-Effekt zeigenden Sensoreinrichtung anzugeben, bei denen Einflüsse von temperaturinduzierter linearer Doppelbrechung und von Intensitätsschwankungen auf das Meßsignal weitgehend kompensiert werden.

Diese Aufgabe wird gemäß der Erfindung gelöst mit den Merkmalen des Anspruchs 1 bzw. des Anspruchs 2. In die unter dem Einfluß eines vom elektrischen Wechselstrom erzeugten Magnetfeldes stehende optische Sensoreinrichtung wird über Einkoppelmittel linear polarisiertes Meßlicht eingekoppelt. Beim Durchlaufen der Sensoreinrichtung wird die Polarisationsebene des Meßlichts in Abhängigkeit vom elektrischen Wechselstrom geändert. Nach Durchlaufen der Sensoreinrichtung wird das Meßlicht von einem Analysator in zwei linear polarisierte Lichtteilsignale mit unterschiedlichen Polarisationsebenen aufgeteilt. Anschließend werden diese beiden Lichtteilsignale von optoelektrischen Wandlern jeweils in entsprechende elektrische Intensitätssignale umgewandelt. Jedes dieser beiden Intensitätssignale wird gesondert intensitätsnormiert, indem von Normierungsmitteln das Quotientensignal aus seinem Wechselsignalanteil und seinem Gleichsignalanteil gebildet wird. Dadurch können Intensitätsschwankungen der optischen Einkoppelmittel und in den Übertragungsstrecken für die beiden Lichtteilsignale kompensiert werden. Aus den beiden Quotientensignalen als intensitätsnormierte Signale I1 und I2 wird nun von Auswertemitteln ein Meßsignal S für den elektrischen Wechselstrom I gemäß der Vorschrift

$$S = (2*S1*S2)/((S2-S1) + K*(S1+S2)) \qquad (1)$$

abgeleitet, wobei K ein reeller Korrekturfaktor ist und dieser Korrekturfaktor K, der Einkoppelwinkel $\eta$ der Polarisationsebene des in die Sensoreinrichtung eingekoppelten Meßlichts zu einer Eigenachse der linearen Doppelbrechung in der Sensoreinrichtung sowie der sogenannte Auskoppelwinkel $\theta$ zwischen dieser Eigenachse der linearen Doppelbrechung und einer Eigenachse des Analysators die folgenden zwei Bedingungen erfüllen:

$$\cos(2\theta + 2\eta) = - 2/(3K) \qquad (2a)$$

$$\sin(2\theta - 2\eta) = 1 . \qquad (2b)$$

Vorteilhafte Ausgestaltungen des Meßverfahrens und der Meßvorrichtung gemäß der Erfindung ergeben sich aus den jeweils abhängigen Ansprüchen.

Zur weiteren Erläuterung der Erfindung wird auf die Zeichnung Bezug genommen, in deren

FIG. 1 ein prinzipieller Aufbau einer Vorrichtung zum Messen eines elektrischen Wechselstromes,

FIG. 2 eine Ausführungsform von Normierungsmitteln für eine solche Meßvorrichtung,

FIG. 3 eine Ausführungsform von Auswertemitteln zur Temperaturkompensation für eine solche Meßvorrichtung und

FIG. 4 ein Einkoppelwinkel $\eta$ und ein Auskoppelwinkel $\theta$ in einem Diagramm

schematisch veranschaulicht sind. Einander entsprechende Teile sind mit denselben Bezugszeichen versehen.

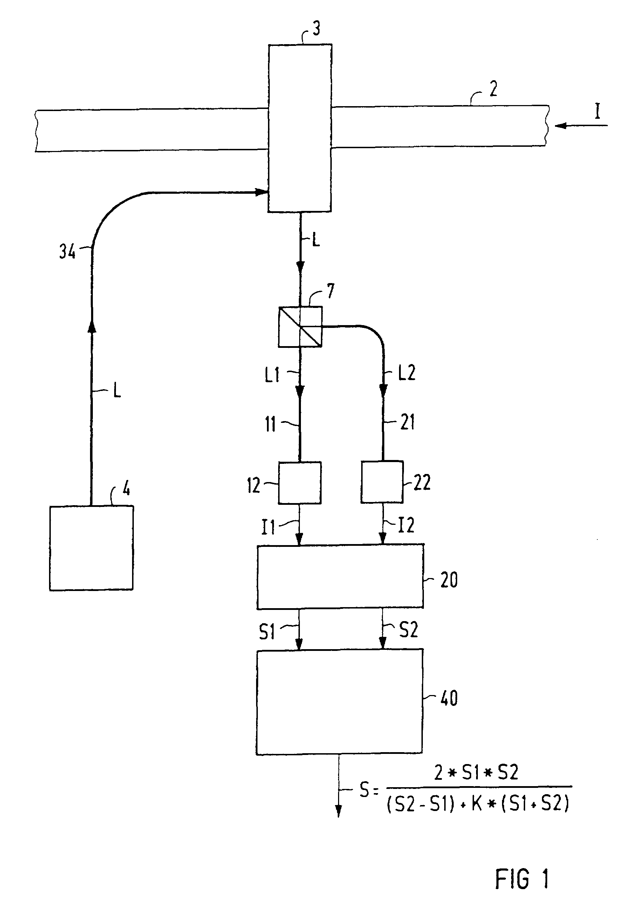

FIG. 1 zeigt eine Ausführungsform der Meßvorrichtung zum Messen eines elektrischen Wechselstromes I in einem Stromleiter 2 in einem prinzipiellen Aufbau. Dem Stromleiter 2 ist eine Sensoreinrichtung 3 zugeordnet, die unter dem Einfluß des von dem elektrischen Wechselstrom I erzeugten Magnetfeldes die Polarisation von in die Sensoreinrichtung 3 eingestrahltem linear polarisierten Meßlicht in Abhängigkeit von dem elektrischen Wechselstrom I ändert. Die Sensoreinrichtung 3 besteht dazu wenigstens teilweise aus wenigstens einem den magnetooptischen Faraday-Effekt zeigenden Material. In die Sensoreinrichtung 3 wird linear polarisiertes Meßlicht L eingekoppelt. Zum Erzeugen dieses linear polarisierten Meßlichts L können eine einfache Lichtquelle und zugeordnete, nicht dargestellte polarisierende Mittel oder auch eine selbst polarisierende Lichtquelle 4, beispielsweise eine Laserdiode, vorgesehen sein. Die Sensoreinrichtung 3 und die Lichtquelle 4

sind vorzugsweise über einen polarisationserhaltenden Lichtleiter 34, beispielsweise eine Monomode-Lichtfaser wie eine HiBi (High-Birefringence)-Faser oder eine polarisationsneutrale LoBi (Low-Birefringence)-Faser, optisch verbunden. Es kann jedoch auch ein Multimode-Lichtleiter, beispielsweise eine in der Telekommunikation verwendete Lichtleitfaser, verwendet werden. Insbesondere im letzten Fall wird das Licht der Lichtquelle 4 direkt vor dem Einkoppeln in die Sensoreinrichtung 3 durch einen zusätzlichen Polarisator geschickt und linear polarisiert. Das linear polarisierte Meßlicht L durchläuft die Sensoreinrichtung 3 wenigstens einmal und erfährt dabei eine von dem elektrischen Wechselstrom I im Stromleiter 2 abhängige Änderung seiner Polarisation. Das ausgekoppelte Meßlicht L weist eine aufgrund des Faraday-Effekts um einen nicht dargestellten Meßwinkel α gedrehte Polarisationsebene auf. Der Meßwinkel α ist dabei abhängig von einem Wechselstrom I in dem Stromleiter 2.

Die Sensoreinrichtung 3 kann mit einem Lichtleiter, vorzugsweise einer optischen Faser, gebildet sein, der den Stromleiter 2 in einer Meßwicklung mit wenigstens einer Meßwindung umgibt. Der Lichtleiter des Sensoreinrichtungs 3 ist mit dem Lichtleiter 34 zum Zuführen des Meßlichts L dann vorzugsweise über einen Spleiß verbunden. Als Sensoreinrichtung 3 können jedoch auch ein oder mehrere massive Körper aus Faraday-Materialien vorgesehen sein, die einen vorzugsweise geschlossenen Lichtpfad um den Stromleiter 2 bilden, beispielsweise ein Glasring. Die Sensoreinrichtung 3 muß den Stromleiter 2 aber nicht in einem geschlossenen Lichtpfad umgeben, sondern kann auch nur in räumliche Nähe neben dem Stromleiter 2 angeordnet sein.

Nach dem Durchlaufen der Sensoreinrichtung 3 wird das Meßlicht L einem Analysator 7 zugeführt und im Analysator 7 in zwei linear polarisierte Lichtteilsignale L1 und L2 zerlegt, deren Polarisationsebenen verschieden voneinander sind. Vorzugsweise sind die Polarisationsebenen der beiden Lichtteilsignale L1 und L2 senkrecht zueinander gerichtet (orthogonale Zerlegung). Als Analysator 7 können ein polarisierender Strahlteiler, beispielsweise ein Wollaston-Prisma, oder auch zwei um einen entsprechenden Winkel und vorzugsweise um 90° gekreuzte Polarisationsfilter und ein einfacher Strahlteiler mit einem teildurchlässigen Spiegel vorgesehen sein. Die Sensoreinrichtung 3 und der Analysator 7 können über eine Freistrahlanordnung oder auch über einen polarisationserhaltenden Lichtleiter, vorzugsweise eine Monomode-Lichtfaser wie beispielsweise eine HiBi (High-Birefringence)-Faser oder eine polarisationsneutrale LoBi (Low-Birefringence)-Faser, optisch miteinander verbunden sein.

Die beiden Lichtteilsignale L1 und L2 werden dann jeweils einem photoelektrischen Wandler 12 bzw. 22 zugeführt. Die Übertragung der beiden Lichtteilsignale L1 und L2 vom Analysator 7 zu dem jeweils zugehörigen Wandler 12 bzw. 22 kann über eine Freistrahlanordnung oder vorzugsweise über jeweils einen Lichtleiter 11 bzw. 21 erfolgen. In den Wandlern 12 und 22 werden die beiden Lichtteilsignale L1 und L2 jeweils in ein elektrisches Intensitätssignal I1 bzw. I2 umgewandelt, das ein Maß für die Intensität des zugehörigen Lichtteilsignals L1 bzw. L2 ist.

Die elektrischen Intensitatssignale I1 und I2 werden nun Normierungsmitteln 20 zugeführt. An jeweils einem Ausgang der Normierungsmittel 20 stehen die intensitätsnormierten Signale S1 und S2 an. Als intensitätsnormierte Signale S1 und S2 werden jeweils der Quotient aus dem Wechselsignalanteil und dem Gleichsignalanteil des zugehörigen Intensitätssignals I1 bzw. I2 gebildet. Die derart gebildeten intensitätsnormierten Signale S1 und S2 sind intensitätsschwankungskompensiert, d. h. Schwankungen in den Lichtintensitäten insbesondere durch Mikrobiegeverluste in den Lichtleitern und infolge von Vibrationen oder sonstigen mechanischen Einwirkungen und durch Schwankungen der Intensität der Lichtquelle 4 sind praktisch eliminiert. Auch unterschiedliche Intensitätsänderungen in den beiden optischen Übertragungsstrecken für die Lichtteilsignale L1 und L2 werden durch diese Intensitätsnormierung kompensiert. Deshalb können als Übertragungsstrecken für die beiden Lichteilsignale L1 und L2 auch jeweils eine Multimode-Faser vorgesehen sein.

Ein Problem bereiten nun jedoch Änderungen der Temperatur aufgrund von temperaturinduzierter linearer Doppelbrechung in den optischen Materialien der optischen Meßvorrichtung, insbesondere der Sensoreinrichtung 3, und die damit verbundene Verschiebung des Arbeitspunktes und insbesondere die Änderung der Meßempfindlichkeit der Meßvorrichtung. Diese temperaturinduzierte Änderung der Meßempfindlichkeit wird durch ein im folgenden beschriebenes Temperaturkompensationsverfahren mit Hilfe von Auswertemitteln 40 weitgehend kompensiert.

Dazu werden die beiden intensitätsnormierten Signale S1 und S2 jeweils einem Eingang der Auswertemittel 40 zugeführt. Die Auswertemittel 40 bilden aus den beiden intensitätsnormierten Signalen S1 und S2 ein Ausgangssignal als Meßsignal S, das zumindest annähernd der vorgenannten Gleichung (1) genügt, also im wesentlichen dem Quotienten aus dem doppelten Produkt 2*S1*S2 der beiden intensitätsnormierten Signale S1 und S2 und der Summe aus der Differenz S2-S1 und der mit einem Korrekturfaktor K multiplizierten Summe S1+S2 der beiden intensitätsnormierten Signale S1 und S2 entspricht.

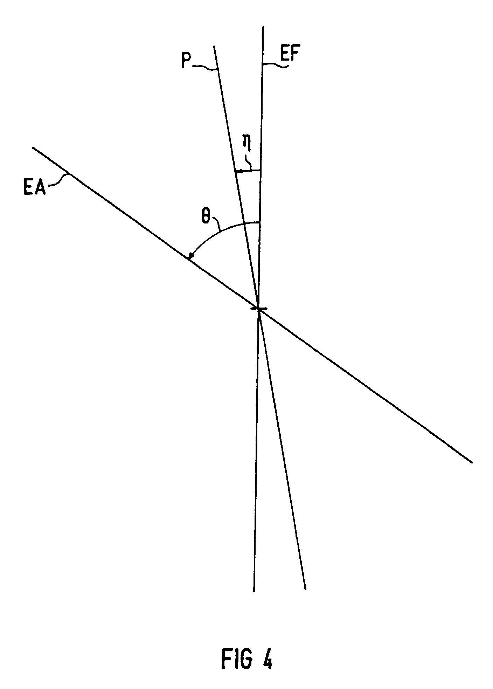

Der Korrekturfaktor K ist eine reelle Zahl, die in Abhängigkeit von einem in FIG. 4 dargestellten Einkoppelwinkel η der Polarisationsebene P des in die Sensoreinrichtung 3 eingekoppelten linear polarisierten Meßlichts L zu einer Eigenachse EF der linearen Doppelbrechung der Sensoreinrichtung 3 einerseits und von einem ebenfalls in FIG. 4 dargestellten Auskoppelwinkel θ zwischen dieser Eigenachse EF und einer Eigenachse EA des Analysators 7 so eingestellt ist, daß wenigstens annähernd die vorgenannten Bedingungen (2a) und (2b) erfüllt sind. Aus Gleichung (2a) folgt insbesondere, daß für den Korrekturfaktor K ≤ -2/3 oder K ≥ 2/3 gilt. Eine Eigenachse eines doppelbrechenden Materials ist dabei durch den Polarisationszustand des Meßlichts L definiert, der das Material unverändert wieder verläßt. In FIG. 4 definiert die Zeichenebene eine Ebene, die senkrecht zur Ausbreitungsrichtung des Meßlichts L gerichtet ist.

Abweichungen von den die genannten Bedingungen (2a) und (2b) exakt erfüllenden Winkelwerten sind insbesondere bei großer linearer und/oder zirkularer Doppelbrechung in der Sensoreinrichtung 3 möglich und können bis zu etwa 5° betragen.

Rechnungen ergaben, daß bei derart in Abhängigkeit vom Korrekturfaktor K gewählten Einkoppelwinkel η und Auskoppelwinkel θ das Meßsignal S eine besonders einfache Abhängigkeit von dem Faraday-Drehwinkel oder Meßwinkel α aufweist. Es gilt nämlich dann in guter Näherung die Beziehung

$$S = \sin(2 \cdot \alpha) \qquad (3).$$

Dieses Meßsignal S entspricht dem theoretischen Meßsignal für den Meßwinkel α ohne Doppelbrechungseffekte. Dadurch wird das Auswerteverfahren besonders einfach. Bei vorgegebenen Einkoppel- und Auskoppelwinkeln η bzw. θ ist der Korrekturfaktor K gerade so einzustellen, daß das Meßsignal S der Meßvorrichtung dem theoretischen Meßsignal bei nicht vorhandener Doppelbrechung entspricht. Mit diesem Korrekturfaktor K ist die Meßvorrichtung dann auf minimale Temperaturabhängigkeit justiert.

Wenn das Meßlicht L vor dem Einkoppeln in die Sensoreinrichtung 3 mit einem Polarisator linear polarisiert wird, kann als Einkoppelwinkel η einfach der Winkel zwischen der Eigenachse dieses Polarisators 5 und einer Eigenachse der linearen Doppelbrechung in der Sensoreinrichtung 3 gewählt werden.

Das Meßsignal S ist sowohl gegenüber Intensitätschwankungen der Lichtquelle und in den optischen Übertragungsstrecken als auch bezüglich seines Arbeitspunktes und seiner Meßempfindlichkeit bei veränderlichen Temperaturen weitgehend stabil. Die arithmetische Herleitung des Meßsignals S gemäß der Gleichung (1) wird vorzugsweise mit Hilfe von entsprechenden analogen Bauelementen für die auszuführenden arithmetischen Operationen durchgeführt. In dieser Ausführungsform ist eine Temperaturkompensation in Echtzeit möglich. Das Meßsignal S kann aber auch digital mit Hilfe eines digitalen Signalprozessors oder eines Mikroprozessors berechnet und/oder mit Hilfe einer gespeicherten Wertetabelle ermittelt werden.

Neben der in FIG. 1 dargestellten Ausführungsform vom Transmissionstyp, bei der das Meßlicht L die Sensoreinrichtung 3 nur in einer Richtung durchläuft, ist auch eine Ausführungsform vom Reflexionstyp möglich, bei der das Meßlicht L nach einem ersten Durchlauf in die Sensoreinrichtung 3 zurückreflektiert wird und die Sensoreinrichtung 3 ein zweites Mal in umgekehrter Richtung durchläuft. Das linear polarisierte Meßlicht L der Lichtquelle 4 wird dann vorzugsweise über einen Strahlteiler an einem optischen Anschluß in die Sensoreinrichtung 3 eingekoppelt und nach dem ersten Durchlauf an einem Spiegel reflektiert, durchläuft die Sensoreinrichtung 3 ein zweites Mal, wird am genannten Anschluß wieder ausgekoppelt und über den Strahlteiler dem Analysator 7 zugeführt.

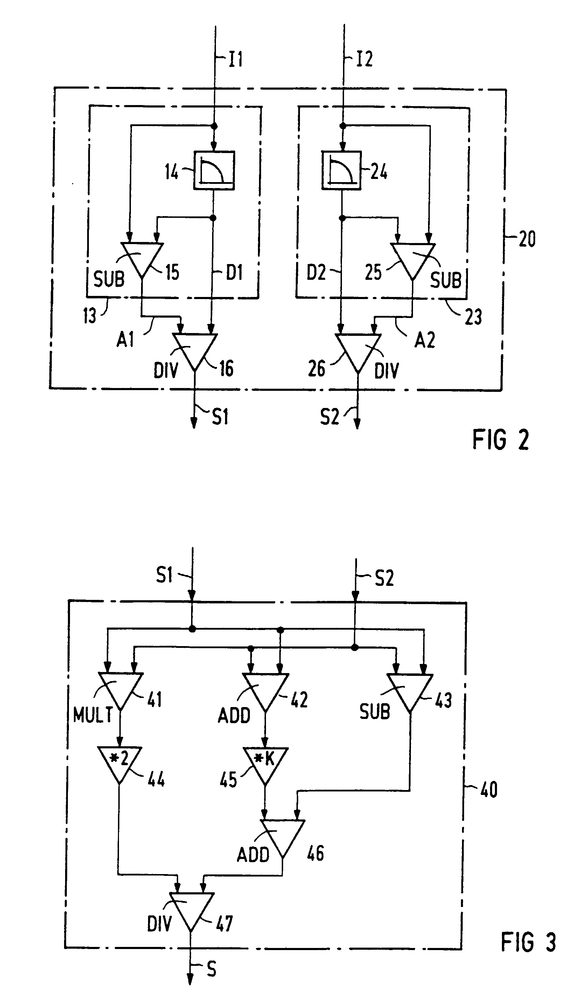

FIG. 2 zeigt eine vorteilhafte Ausführungsform der Normierungsmittel 20. Es sind ein erstes, mit dem optoelektrischen Wandler 12 elektrisch verbundenes Filter 13 zum Zerlegen des ersten Intensitätssignals I1 in einen Wechselsignalanteil A1 und einen Gleichsignalanteil D1 und ein zweites, mit dem zweiten optoelektrischen Wandler 22 elektrisch verbundenes Filter 23 zum Zerlegen des zweiten Intensitätssignals I2 in einen Wechselsignalanteil A2 und einen Gleichsignalanteil D2 vorgesehen. Die Trennfrequenzen beider Filter 13 und 23 sind dabei so hoch gewählt, daß die Wechselsignalanteile A1 und A2 der Intensitätssignale im wesentlichen alle Informationen über den zu messenden Wechselstrom I enthalten. Insbesondere ist die Trennfrequenz kleiner als die Grundfrequenz des Wechselstromes I zu wählen. In der dargestellten Ausführungsform enthalten beide Filter 13 und 23 jeweils ein Tiefpaßfilter 14 bzw. 24 und einen Subtrahierer (SUB) 15 bzw. 25. Das Intensitätssignal I1 oder I2 wird an einen Eingang des zugehörigen Tiefpaßfilters 14 bzw. 24 angelegt. An einem Ausgang des Tiefpaßfilters 14 bzw. 24 steht dann der Gleichsignalanteil D1 bzw. D2 des Intensitätssignals I1 bzw. I2 an, der den Frequenzanteilen des Intensitätssignals I1 bzw. I2 entspricht, die unterhalb einer vorgegebenen Trennfrequenz des Tiefpaßfilters 14 bzw. 24 liegen. Der jeweilige Wechselsignalanteil AI oder A2 wird nun einfach durch Subtraktion des Gleichsignalanteils D1 bzw. D2 vom Intensitätssignal I1 bzw. I2 mit Hilfe jeweils eines Subtrahierers 15 bzw. 25 gebildet. Dazu werden an zwei Eingängen des zugehörigen Subtrahierers 15 oder 25 das Intensitätssignal I1 bzw. I2 und der zugehörige Gleichsignalanteil D1 bzw. D2 angelegt.

Anstelle der in FIG. 2 gezeigten Ausführungsformen der Filter 13 und 23 können natürlich auch Hochpaßfilter und Tiefpaßfilter zum Herausfiltern der Wechselsignalanteile A1 und A2 bzw. der Gleichsignalanteile D1 und D2 vorgesehen sein oder auch jeweils ein Hochpaßfilter zum Herausfiltern des Wechselsignalanteils AI oder A2 und ein Subtrahierer zum Ableiten des Gleichsignalanteils D1=I1-A1 bzw. D2=I2-A2.

Der Wechselsignalanteil AI und der Gleichsignalanteil D1 des ersten Intensitätssignals I1 werden nun jeweils einem Eingang eines Dividierers 16 zugeführt. An einem Ausgang des Dividierers 16 steht dann das erste intensitätsnormierte Signal S1 = A1/D1 als Quotient aus Wechselsignalanteil A1 und Gleichsignalanteil D1 des ersten Intensitätssignals I1 an. Ebenso werden der Wechselsignalanteil A2 und der Gleichsignalanteil D2 des zweiten Intensitätssignals I2 einem zweiten Dividierer 26 zugeführt, der das intensitätsnormierte Signal $S2 = A2/D2$ für das zweite Intensitätssignal I2 bildet. Die beiden intensitäsnormierten Signale S1 und S2 können dann an entsprechenden Ausgängen der Normierungsmittel 20 abgegriffen werden.

Die FIG. 3 zeigt eine Ausführungsform der Auswertemittel 40 mit analoger Hardware. Es sind ein Multiplizierer (MULT) 41, ein erster Addierer (ADD) 42, ein Subtrahierer (SUB) 43, zwei Verstärker 44 und 45, ein zweiter Addierer (ADD) 46 und ein Dividierer (DIV) 47 vorgesehen. Die beiden intensitätsnormierten Signale S1 und S2 der Normierungsmittel 20 werden jeweils zwei Eingängen des Multiplizierers 41, des ersten Addierers 42 und des Subtrahierers 43 zugeführt. Das Produkt S1∗S2 der beiden Signale S1 und S2 am Ausgang des Multiplizierers 41 wird einem Eingang des Verräters 44 zugeleitet. Der Verstärker 44 ist auf einen Verstärkungsfaktor 2 eingestellt, so daß an seinem Ausgang das doppelte Produkt 2∗S1∗S2 der beiden Signale S1 und S2 ansteht. Die Summe S1+S2 der beiden Signale S1 und S2 am Ausgang des ersten Addierers 42 wird an einen Eingang des weiteren Verstärkers 45 angelegt und um den Korrekturfaktor K verstärkt. Der Verstärkungsfaktor des Verstärkers 45 ist dazu auf den vorgegebenen Korrekturfaktor K einzustellen. Das Produkt K∗(S1+S2) am Ausgang des Verstärkers 45 wird einem Eingang des zweiten Addierers 46 zugeführt. An den anderen Eingang dieses Addierers 46 wird das Ausgangssignal S2-S1 des Subtrahierers 43 angelegt, das der Differenz der beiden Signale S1 und S2 entspricht. Als Summe seiner beiden Eingangssignale bildet der Addierer 46 das Ausgangssignal K∗(S1+S2)+(S2-S1). Schließlich werden das Ausgangssignal 2∗S1∗S2 des Verstärkers 44 dem ersten Eingang des Dividierers 47 und das Ausgangssignal des zweiten Addierers 46 dem zweiten Eingang des Dividierers 47 zugeführt. Der Dividierer 47 berechnet aus diesen beiden Eingangssignalen das Meßsignal

$$S = (2∗S1∗S2)/(K∗(S1+S2)+(S2-S1))$$

gemäß Gleichung (1). Diese Ausführungsform mit analogen Bauelementen gemäß FIG. 3 hat den Vorteil, daß die Berechnung des Meßsignals S besonders schnell durchgeführt wird. Insbesondere in Kombination mit Normierungsmitteln 20 gemäß FIG. 2 ist so eine Temperaturkompensation in Echtzeit möglich.

Das Meßverfahren und die Meßvorrichtung gemäß der Erfindung können natürlich auch direkt zum Messen von magnetischen Wechselfeldern verwendet werden, indem die Sensoreinrichtung 3 in dem magnetischen Wechselfeld angeordnet wird.

## Patentansprüche

1. Verfahren zum Messen eines elektrischen Wechselstromes (I) unter Ausnutzung des Faraday-Effekts mit folgenden Merkmalen:

   a) es wird linear polarisiertes Meßlicht (L) in eine unter dem Einfluß eines vom elektrischen Wechselstrom (I) erzeugten Magnetfeldes stehende Sensoreinrichtung (3) eingekoppelt, und die Polarisationsebene des Meßlichts (L) wird beim Durchlaufen der Sensoreinrichtung (3) in Abhängigkeit vom elektrischen Wechselstrom (I) gedreht;
   b) das Meßlicht (L) wird nach wenigstens einmaligem Durchlaufen der Sensoreinrichtung (3) von einem Analysator (7) in zwei linear polarisierte Lichtteilsignale (L1,L2) mit unterschiedlichen Polarisationsebenen aufgeteilt;
   c) die beiden Lichtteilsignale (L1,L2) werden jeweils in ein elektrisches Intensitatssignal (I1,I2) umgewandelt;
   d) für jedes dieser beiden elektrischen Intensitatssignale (I1,I2) wird ein intensitatsnormiertes Signal S1 bzw. S2 gebildet, das dem Quotienten aus einem Wechselsignalanteil und einem Gleichsignalanteil des zugehörigen Intensitätssignals (I1,I2) entspricht;
   e) aus den beiden intensitätsnormierten Signalen S1 und S2 wird nun ein Meßsignal S für den elektrischen Wechselstrom (I) gemäß der Vorschrift

   $$S = (2∗S1∗S2)/((S2-S1) + K∗(S1+S2))$$

   abgeleitet, wobei der reelle Korrekturfaktor K, ein Einkoppelwinkel $\eta$ der Polarisationsebene des in die Sensoreinrichtung (3) eingekoppelten Meßlichts (L) zu einer Eigenachse der linearen Doppelbrechung in der Sensoreinrichtung (3) sowie ein Auskoppelwinkel $\theta$ zwischen dieser Eigenachse der linearen Doppelbrechung und einer Eigenachse des Analysators (7) die folgenden zwei Bedingungen erfüllen:

   $$\cos(2\theta + 2\eta) = - 2/(3K)$$

   $$\sin(2\theta - 2\eta) = 1.$$

2. Vorrichtung zum Messen eines elektrischen Wechselstromes (I) mit

   a) Einkoppelmitteln (4,34) zum Einkoppeln linear polarisierten Meßlichts (L) in eine unter dem Einfluß eines vom Wechselstrom (I) erzeugten Magnetfeldes stehende Sensoreinrichtung (3), die die Polarisationsebene des Meßlichts (L) in Abhängigkeit vom elektrischen Wechselstrom (I) dreht,

b) einem Analysator (7) zum Aufteilen des Meßlichts (L) nach wenigstens einmaligem Durchlaufen der Sensoreinrichtung (3) in zwei linear polarisierte Lichtteilsignale (L1,L2) mit unterschiedlichen Polarisationsebenen,

c) optoelektrischen Wandlern (12,22) zum Umwandeln der beiden Lichtteilsignale (L1,L2) in jeweils ein elektrisches - Intensitätssignal (I1,I2),

d) Normierungsmitteln (13,23), die für beide Intensitätssignale (I1,I2) jeweils ein intensitätsnormiertes Signal S1 bzw. S2 bilden, das dem Quotienten aus einem Wechselsignalanteil und einem Gleichsignalanteil des zugehörigen Intensitätssignal (I1,I2) entspricht;

e) Auswertemitteln (20) zum Ableiten eines Meßsignal S für den elektrischen Wechselstrom (I) aus den beiden intensitätsnormierten Signalen S1 und S2 gemäß der Vorschrift

$$S = (2*S1*S2)/((S2-S1) + K*(S1+S2)),$$

wobei K ein reeller Korrekturfaktor ist und dieser Korrekturfaktor K, ein Einkoppelwinkel $\eta$ der Polarisationsebene des in die Sensoreinrichtung (3) eingekoppelten Meßlichts (L) zu einer Eigenachse der linearen Doppelbrechung in der Sensoreinrichtung (3) sowie ein Auskoppelwinkel $\theta$ zwischen dieser Eigenachse der linearen Doppelbrechung und einer Eigenachse des Analysators (7) die folgenden zwei Bedingungen erfüllen:

$$\cos(2\theta + 2\eta) = - 2/(3K)$$

$$\sin(2\theta - 2\eta) = 1 .$$

3. Vorrichtung nach Anspruch 2, bei der als Analysator (7) ein Wollaston-Prisma vorgesehen ist.

4. Vorrichtung nach Anspruch 2 oder Anspruch 3, bei der der Analysator (7) mit den optoelektrischen Wandlern (12,22) über jeweils einen Lichtleiter (11,21) für jedes Lichtteilsignal (L1,L2) optisch verbunden ist.

5. Vorrichtung nach Anspruch 4, bei der die Lichtleiter (11,21) Multimode-Fasern sind.

6. Vorrichtung nach einem der Ansprüche 2 bis 5, bei der die Sensoreinrichtung (3) und der Analysator (7) über eine polarisationserhaltende Lichtleitfaser zum Übertragen des aus der Sensoreinrichtung (3) ausgekoppelten Meßlichts (L) optisch miteinander verbunden sind.

7. Vorrichtung nach einem der Ansprüche 2 bis 6, bei der als Sensoreinrichtung (3) ein Glasring vorgesehen ist.

**Claims**

1. Method for measuring an electric alternating current (I) by using the Faraday effect, having the following features:

a) linearly polarized measuring light (L) is coupled into a sensor equipment (3) which is under the influence of a magnetic field generated by the electric alternating current (I), and the plane of polarization of the measuring light (L) is rotated while passing through the sensor equipment (3), as a function of the electric alternating current (I);

b) the measuring light (L), after passing at least once through the sensor equipment (3), is split by an analyser (7) into two linearly polarized light partial signals (L1, L2) having different planes of polarization;

c) the two light partial signals (L1, L2) are in each case converted into an electric intensity signal (I1, I2);

d) for each of these two electric intensity signals (I1, I2) an intensity-normalized signal S1 and S2 is formed, which corresponds to the quotient of an AC signal component and a DC signal component of the associated intensity signal (I1, I2);

e) a measured signal S for the electric alternating current I is now derived from the two intensity-normalized signals S1 and S2 in accordance with the rule

$$S = (2*S1*S2)/((S2-S1) + K*(S1+S2))$$

where the real correction factor K, an input coupling angle $\eta$ of the plane of polarization of the measuring light (L) coupled into the sensor equipment (3) to an intrinsic axis of the linear birefringence in the sensor equipment (3), and an output coupling angle $\theta$ between this intrinsic axis of the linear birefringence and an intrinsic axis of the analyser (7) fulfil the following two conditions:

$$\cos(2\theta + 2\eta) = - 2/(3K)$$

$$\sin(2\theta - 2\eta) = 1.$$

2. Device for measuring an electric alternating current (I) having

a) input coupling means (4, 34) for coupling linearly polarized measuring light (L) into a sensor equipment (3) which is under the influence of a magnetic field generated by the alternating current (I), and rotates the plane of polarization of the measuring light (L) as a function of the electric alternating current (I),
b) an analyser (7) for splitting the measuring light (L), after passing at least once through the sensor equipment (3), into two linearly polarized light partial signals (L1, L2) having different planes of polarization,
c) optoelectric converters (12, 22) for converting the two light partial signals (L1, L2) into one electric intensity signal (I1, I2) in each case,
d) normalizing means (13, 23) which, for both intensity signals (I1, I2) in each case form an intensitynormalized signal S1 and S2 which corresponds to the quotient of an AC signal component and a DC signal component of the associated intensity signal (I1, I2);
e) evaluation means (20) for deriving a measured signal S for the electric alternating current (I) from the two intensity-normalized signals S1 and S2 in accordance with the rule

$$S = (2*S1*S2)/((S2-S1) + K*(S1+S2)),$$

where K is a real correction factor and this correction factor K, an input coupling angle $\eta$ of the plane of polarization of the measuring light (L) coupled into the sensor equipment (3) to an intrinsic axis of the linear birefringence in the sensor equipment (3), and an output coupling angle $\theta$ between this intrinsic axis of the linear birefringence and an intrinsic axis of the analyser (7) fulfil the following two conditions:

$$\cos(2\theta + 2\eta) = - 2/(3K)$$

$$\sin(2\theta - 2\eta) = 1.$$

3. Device according to Claim 2, in which a Wollaston prism is provided as analyser (7).

4. Device according to Claim 2 or Claim 3, in which the analyser (7) is optically connected to the optoelectric converters (12, 22) via in each case an optical waveguide (11, 21) for each light partial signal (L1, L2).

5. Device according to Claim 4, in which the optical waveguides (11, 21) are multimode fibres.

6. Device according to one of Claims 2 to 5, in which the sensor equipment (3) and the analyser (7) are optically connected to each other, for transmitting the measuring light (L) coupled out of the sensor equipment (3), via a polarization-maintaining optical fibre.

7. Device according to one of Claims 2 to 6, in which a glass ring is provided as sensor equipment (3).

**Revendications**

1. Procédé de mesure d'un courant alternatif électrique (I), en tirant parti de l'effet Faraday, ayant les caractéristiques suivantes :

a) on introduit de la lumière de mesure (L) polarisée linéairement dans un dispositif capteur (3) se trouvant sous l'influence d'un champ magnétique produit par le courant alternatif électrique (I) et le plan de polarisation de la lumière de mesure (L) subit une rotation lors du passage dans le dispositif capteur (3) en fonction du courant alternatif électrique (I) ;
b) après au moins un passage dans le dispositif capteur (3), on sépare à l'aide d'un analyseur (7) la lumière de mesure (L) en deux signaux partiels lumineux (L1, L2) polarisés linéairement et ayant des plans de polarisation différents ;
c) on convertit les deux signaux partiels lumineux (L1, L2) en deux signaux d'intensités électriques (I1, I2) ;
d) pour chacun de ces deux signaux d'intensités électriques (I1, I2), on forme un signal à intensité normée (S1, S2), qui correspond au quotient d'une composante alternative et d'une composante continue du signal d'intensité (I1, I2) associé ;
e) à partir des deux signaux à intensité normée (S1, S2), on déduit un signal de mesure (S) du courant alternatif électrique (I) selon la relation

$$S = (2*S1*S2) / ((S2-S1) + K*(S1+S2))$$

le facteur correcteur réel K, l'angle d'entrée $\eta$ du plan de polarisation de la lumière de mesure (L) introduite dans le dispositif capteur (3) par rapport à un axe propre de la double réfraction linéaire dans le dispositif capteur (3) ainsi que l'angle de sortie $\theta$ entre cet axe propre de la double réfraction linéaire et un axe propre de l'analyseur (7) remplissant les deux conditions suivantes :

$$\cos(2\theta + 2\eta) = - 2/(3K)$$

$$\sin(2\theta - 2\eta) = 1 .$$

2. Dispositif de mesure d'un courant alternatif électrique (I) comportant

   a) des moyens (4, 34) pour introduire de la lumière de mesure (L) polarisée linéairement dans un dispositif capteur (3) qui se trouve sous l'influence d'un champ magnétique produit par le courant alternatif électrique (I) et qui fait tourner le plan de polarisation de la lumière de mesure (L) en fonction du courant alternatif électrique (I) ;
   b) un analyseur (7) pour séparer la lumière de mesure (L), après au moins un passage dans le dispositif capteur (3), en deux signaux partiels lumineux (L1, L2) polarisés linéairement et ayant des plans de polarisation différents ;
   c) des convertisseurs optoélectriques (12, 22) pour convertir les deux signaux partiels lumineux (L1, L2) respectivement en deux signaux d'intensités électriques (I1, I2) ;
   d) des moyens de calcul de norme (13, 23) qui forment pour les deux signaux d'intensités (I1, I2) respectivement des signaux à intensité normée (S1, S2) qui correspondent au quotient d'une composante alternative et d'une composante continue du signal d'intensité (I1, I2) associé ;
   e) des moyens d'exploitation (40) pour déduire un signal de mesure (S) du courant alternatif électrique (I) à partir des deux signaux à intensité normée (S1, S2) selon la relation

   $$S = (2*S1*S2) / ((S2-S1) + K*(S1+S2)),$$

   K étant un facteur correcteur réel et ce facteur correcteur K, un angle d'entrée $\eta$ du plan de polarisation de la lumière de mesure (L) introduite dans le dispositif capteur (3) par rapport à un axe propre de la double réfraction linéaire dans le dispositif capteur (3) ainsi qu'un angle de sortie $\theta$ entre cet axe propre de la double réfraction linéaire et un axe propre de l'analyseur (7) remplissant les deux conditions suivantes :

   $$\cos(2\theta + 2\eta) = - 2/(3K)$$

$$\sin(2\theta - 2\eta) = 1 .$$

3. Dispositif selon la revendication 2, dans lequel un prisme de Wollaston est prévu comme analyseur (7).

4. Dispositif selon la revendication 2 ou 3, dans lequel l'analyseur (7) est relié optiquement aux convertisseurs optoélectriques (12, 22) par l'intermédiaire d'un guide de lumière (11, 21) pour chaque signal partiel lumineux (L1, L2).

5. Dispositif selon la revendication 4, dans lequel les guides de lumière (11, 21) sont des fibres multimodales.

6. Dispositif selon l'une des revendications 2 à 5, dans lequel le dispositif capteur (3) et l'analyseur (7) sont reliés optiquement par l'intermédiaire d'une fibre optique conservant la polarisation et destinée à transmettre la lumière de mesure (L) sortie du dispositif capteur (3).

7. Dispositif selon l'une des revendications 2 à 6, dans lequel un anneau de verre est prévu comme dispositif capteur (3).

$$S = \frac{2 * S1 * S2}{(S2 - S1) + K * (S1 + S2)}$$

FIG 1

I1    I2

14    24

SUB 15    D1    D2    25    SUB

13    23    20

A1    DIV 16    26    DIV    A2

S1    S2

FIG 2

S1    S2

MULT 41    ADD 42    SUB 43

*2 44    45 *K    40

ADD 46

DIV 47

S

FIG 3

11

FIG 4